# EUROPÄISCHE PATENTSCHRIFT

(11) **EP 0 923 111 B1**
(45) Veröffentlichungstag und Bekanntmachung des Hinweises auf die Patenterteilung: **02.05.2007**
(21) Anmeldenummer: 98811128.2
(22) Anmeldetag: 11.11.1998
(51) Int. Cl.: H01L 21/00

(54) **Halbleiter-Montageeinrichtung mit einem hin und her geführten Chipgreifer**
Semiconductor mounting apparatus with a reciprocating chip gripper
Dispositif pour le montage de semiconducteur avec un organe préhenseur pour puce, animé d'un mouvement de va-et-vient

(30) Priorität: 07.12.1997 CH 280797; 11.05.1998 EP 98810426
(43) Veröffentlichungstag der Anmeldung: 16.06.1999
(73) Patentinhaber: Oerlikon Assembly Equipment AG, Steinhausen, 6330 Cham (CH)
(72) Erfinder: Schindler, Samuel, 8810 Horgen (CH)
(74) Vertreter: Falk, Urs

(56) Entgegenhaltungen:
- EP-A- 0 778 610
- US-A- 4 221 533
- US-A- 4 728 252
- US-A- 4 813 846
- US-A- 5 049 029
- US-A- 5 516 026

## Beschreibung

Die Erfindung betrifft eine Halbleiter-Montageeinrichtung mit einem Chipgreifer, welcher zwischen einem ersten Ort und einem zweiten Ort mittels eines Hebelmechanismus hin und her bewegbar ist, um jeweils am ersten Ort einen Chip von einem Chipträger abzuheben und am zweiten Ort den Chip auf ein Substrat abzulegen. Eine derartige, als "Pick-and-Place" bezeichnete Einrichtung wird als Bestandteil eines "Die Bonder" genannten Montageautomaten bei der Halbleitermontage verwendet. Sie dient dazu, die zahlreichen, gleichartigen Chips eines Wafers, die sich nebeneinander auf einem Träger befinden, nacheinander auf einem Substrat, z.B. einem metallischen Leadframe, zu montieren. Mit jeder Pick-and-Place-Bewegung koordiniert stellt jeweils der Wafertisch, auf dem sich der Chipträger befindet, einen nächsten Chip am genannten ersten Ort bereit, und ebenso wird das Substrat verschoben, um am zweiten Ort einen neuen Substratplatz bereitzustellen. Zum Abheben und nachfolgenden Ablegen der Chips ist der Chipgreifer in bekannter Weise heb- und senkbar, entweder zusammen mit der ganzen Einrichtung oder für sich allein relativ zur Einrichtung.

An Montageeinrichtungen dieser Art werden extrem hohe Anforderungen gestellt. Für die Weiterverarbeitung der montierten Chips (Kontaktierung der integrierten Schaltung im Wire Bonder) müssen diese lagegenau auf dem Substrat positioniert werden, was ein entsprechend genaues Erreichen des zweiten Ortes durch den Chipgreifer verlangt und auch bereits das genaue Anfahren des ersten Ortes für das Abheben der Chips voraussetzt. Anderseits werden auch hohe Geschwindigkeiten bzw. kurze Taktzeiten der Bewegungsspiele verlangt, wodurch entsprechend hohe Beschleunigungen und Massenkräfte an den bewegten Teilen auftreten.

Zur Erzeugung der alternierenden Bewegungen des Chipgreifers werden bisher verschiedene Hebelmechanismen angewendet, die teilweise Kulissenführungen enthalten (z.B. nach Art des bekannten Maltesergetriebes). Derartige Führungen sind wegen den an ihnen auftretenden, erheblichen Querkräften für einen präzisen Bewegungsablauf nachteilig und müssen entsprechend gewartet werden. Bei einem anderen bekannten Mechanismus sitzt der Chipgreifer am Ende eines hin und her schwenkenden Hebels, d.h. er erfährt entsprechend den Schwenkausschlägen des Hebels eine bogenförmige Bewegung, die jeweils in den Endlagen gestoppt werden muss, wobei eine starke Neigung zu Schwingungen besteht.

Mit den bekannten Anordnungen ist es deshalb schwierig, die in der Praxis bestehenden Anforderungen sowohl bezüglich Genauigkeit als auch Geschwindigkeit zu erfüllen (siehe z.B.: US-A-4221533; Anmelder: Texas Instruments; Offenlegungstag: 9.9. 1980).

Mit der Erfindung wird angestrebt, bei einer Halbleiter-Montageeinrichtung der eingangs genannten Art die vorerwähnten, beim Stand der Technik bestehenden Nachteile zu überwinden. Der Bewegungsmechanismus soll vor allem eine genaue Positionierung des Chipgreifers in den beiden Endlagen sicherstellen, dabei aber auch schnelle Hin- und Herbewegungen, d.h. kurze Taktzeiten ermöglichen.

Diese Aufgabe wird erfindungsgemäss mit den kennzeichnenden Merkmalen des Patentanspruches 1 gelöst. Demnach weist der Hebelmechanismus der Einrichtung einen ersten Schwenkhebel auf, der auf einer im gleichen Abstand zum ersten und zum zweiten Ort gelagerten Welle sitzt und mit wechselnder Schwenkrichtung zwischen zwei Endlagen angetrieben ist, in denen er je zur Seite des einen oder des anderen Ortes hin weist. Ein zweiter Schwenkhebel ist am Ende des ersten Schwenkhebels gelagert. Er ist bezüglich der Schwenkrichtung des ersten Schwenkhebels gegensinnig sowie mit einer bestimmten Übersetzung zu dessen Schwenkbewegung angetrieben; an seinem Ende ist er mit dem Chipgreifer verbunden. Die genannte Übersetzung sowie die Längen beider Schwenkhebel sind in bestimmter Weise aufeinander abgestimmt, nämlich so, dass in den beiden Endlagen des ersten Schwenkhebels beide Schwenkhebel sich zueinander in Strecklage befinden und der Chipgreifer über dem einen bzw. dem andern Ort angelangt ist.

Eine solche Abstimmung ist jeweils dann gegeben, wenn gilt:

| | | |
|---|---|---|
| n = 360°/Φ ; | h1/h2 = n-1 ; | h1+h2 = S , |

wobei:
- n =: Übersetzung
- Φ =: Schwenkbereich des ersten Schwenkhebels zwischen den Endlagen
- h1 =: Länge des ersten Schwenkhebels
- h2 =: Länge des zweiten Schwenkhebels
- S =: Abstand zwischen der Schwenkachse des ersten Schwenkhebels und dem ersten bzw. dem zweiten Ort

Wie ersichtlich (auch anhand weiter unten beschriebener konkreter Beispiele), sind verschiedene Ausführungen mit unterschiedlichen, aufeinander abgestimmten Schwenkbereichen, Übersetzungen und Hebelverhältnissen möglich. In Bezug auf die Aufgabe der Erfindung ist an dieser Art von Hebelmechanismus vor allem der Umstand wesentlich, dass am Ende eines jeden Bewegungsspiels der Chipgreifer seine Endposition (d.h. den ersten bzw. den zweiten Ort) jeweils in der Richtung der gestreckten Schwenkhebel erreicht, es verschwindet also in den Endlagen jegliche Bewegungskomponente quer zur Längsrichtung der Hebel. Auch die Massekraft des beschleunigten Chipgreifers wirkt dann in Richtung der gestreckten Hebel und trägt gewissermassen zur Stabilisierung der Strecklage bei. Schliesslich ist in den Strecklagen ein allfälliges Überschwingen des ersten Schwenkhebels (der am Ende seines Schwenkbereiches gestoppt werden muss) von verschwindendem Einfluss auf die Endlage des Chipgreifers. Solche günstigen kinematischen und dynamischen Eigenschaften des Hebelmechanismus verleihen der erfindungsgemässe Montageeinrichtung eine hohe und langzeitstabile Positioniergenauigkeit und erlauben zugleich kurze Taktzeiten.

Eine besonders einfache und vorteilhafte Ausführung der Einrichtung ergibt sich mit dem Schwenkbereich Φ = 180°, der Übersetzung n = 2 und dem Hebelverhältnis h1/h2 = 1. Ein Hebelmechanismus mit diesen Parametern ist an sich bekannt als sogenannte Geradführung, was bedeutet, dass ein von ihm bewegter Körper - hier der Chipgreifer - sich auf einer Geraden bewegt.

Wie weiter oben erwähnt, ist die erfindungsgemässe Einrichtung aber grundsätzlich auch mit anderen Parametern (selbst mit nicht ganzzahligen Werten von n) realisierbar. Besondere weitere Ausgestaltungen der im Patentanspruch 1 definierten, erfindungsgemässen Einrichtung sind in den abhängigen Ansprüchen angegeben.

Nachstehend wird die Erfindung anhand von Ausführungsbeispielen in Verbindung mit der Zeichnung näher erläutert.
- Fig. 1: ist die Seitenansicht eines ersten Ausführungsbeispiels der erfindungsgemässen Halbleiter-Montageeinrichtung in vereinfachter Darstellung,
- Fig. 2: ist die Draufsicht der Einrichtung nach Fig. 1 (Wafer und Substrat weggelassen),
- Fig. 3 und 4: sind Zeitdiagramme zu der Einrichtung nach Fig. 1 und 2,
- Fig. 5: veranschaulicht ein weiteres Ausführungsbeispiel in Draufsicht, und
- Fig. 6: zeigt Anschlagsmittel.

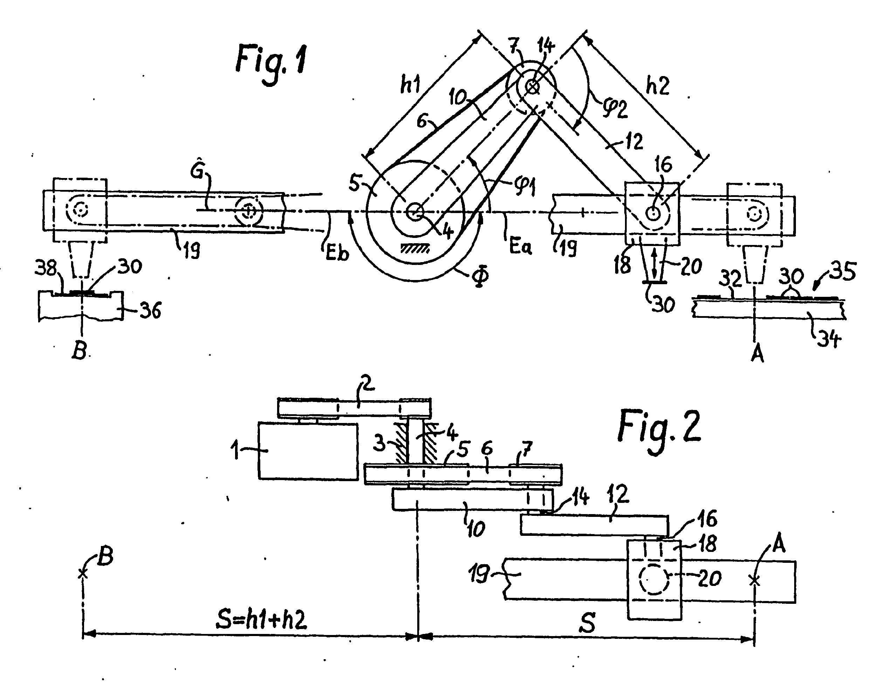

Die Halbleiter-Montageeinrichtung nach Fig. 1 und 2 ist Bestandteil eines nicht weiter dargestellten und an sich bekannten, "Die Bonder" genannten Montageautomaten. Sie dient dazu, mittels eines Chipgreifers 20 taktweise jeweils an einem ersten Ort A einen Halbleiterchip 30 von einem Chipträger 32 abzuheben und, nach Verschieben des Chipgreifers, den Chip an einem zweiten Ort B auf ein Substrat 38 abzulegen ("Pick-and-Place"). Der Chipträger 32 (typischerweise eine Haftfolie) mit den Chips eines Wafers 35 befindet sich auf einem verschiebbaren Wafertisch 34, der jeweils einen nächsten Chip 30 am Ort A bereitstellt. Das Substrat 38, z.B. ein metallischer Leadframe, liegt auf einer als "Indexer" bezeichneten Verschiebeeinrichtung 36 auf, die das Substrat jeweils schrittweise vorschiebt, um am Ort B einen freien Substratplatz für die Aufnahme des nachfolgenden Chips bereitzustellen. Wafertisch und Indexer sind an sich bekannte Baueinheiten und, weil nicht Gegenstand der Erfindung, nicht näher dargestellt (und in Fig. 2 ganz weggelassen). Zum Abheben und nachfolgenden Ablegen der Chips 30 kann der Chipgreifer 20 (Bestandteil eines sogenannten Bondkopfes), wie in Fig. 1 schematisch mit Pfeilen angedeutet, relativ zur Pick-and-Place-Einrichtung heb- und senkbar sein, es kann aber auch die Einrichtung als Ganzes vertikal beweglich (in Fig. 1 gesehen) ausgeführt sein.

Die Pick-and-Place-Einrichtung gemäss Fig. 1 und 2 weist einen ersten Schwenkhebel 10 auf der auf einer Welle 4 festsitzt. Die Welle 4 ist mittig zwischen den Orten A und B gelagert (Lager 3, Fig. 2), d.h. die Schwenkachse des Hebels 10 weist den gleichen Abstand S zu A und zu B auf. Ein zweiter Schwenkhebel 12 ist mittels der Welle 14 am Ende des ersten Schwenkhebels gelagert. Das Ende des zweiten Hebels wiederum ist über eine Achse 16 mit einem Schlitten 18 verbunden. Dieser trägt den Chipgreifer 20 und gleitet entlang einer Linearführung 19, die sich zwischen A und B erstreckt.

Ein ortsfester Schwenkantrieb, z.B. bestehend aus Motor 1 und Zahnriemengetriebe 2 (nur in Fig. 2 angedeutet) treibt den ersten Hebel 10 über die Welle 4 mit wechselnder Schwenkrichtung an. Der Hebel 10 bestreicht dabei einen Schwenkbereich Φ zwischen zwei Endlagen Ea, Eb, in denen er jeweils zum einen Ort A bzw. zum andern Ort B hin weist. In der Fig. 1 sind die Endlagen der Schwenkhebel und des Chipgreifers strichpunktiert angedeutet, eine Zwischenstellung (mit dem Schwenkwinkel ϕ1 des Hebels 10) dagegen mit ausgezogenen Linien gezeichnet. Die Endlagen Ea und Eb des ersten Winkelhebels 10 werden durch eine geeignete Antriebssteuerung des Motors 1 bestimmt und eingehalten.

Der zweite Schwenkhebel 12 wird vom ersten Hebel 10 nicht "passiv" mitgenommen, sondern erfährt einen Antrieb mit bestimmter Übersetzung relativ zum ersten Hebel sowie gegensinnig zu dessen Schwenkrichtung. Gemäss dargestelltem Beispiel ist dieser Antrieb mittels eines Zahnriemens 6 verwirklicht, der ein feststehendes, zur Welle 4 koaxiales Zahnrad 5 und ein auf der Welle 14 festsitzendes Zahnrad 7 umschlingt (anstelle des Zahnriemens 6 könnte man auch ein am Hebel 10 gelagertes Zwischenzahnrad vorsehen, welches mit den Zahnrädern 5 und 7 kämmt). Damit sind die Schwenkbewegungen der beiden Hebel 10 und 12 (Schwenkwinkel ϕ1 bzw. ϕ2) in bestimmter Weise miteinander gekoppelt.

Beim gegebenen Schwenkbereich Φ von 180° ist die Übersetzung n zwischen den Hebeln 10 und 12 gleich **2**, d.h. in jeder Hebelstellung beträgt der Winkel ϕ2 des Hebels 12 relativ zum Hebel 10 das Doppelte des Schwenkwinkels ϕ1 des Hebels 10. Ferner ist wesentlich, dass die Hebel 10 und 12 gleiche Längen h1 und h2 aufweisen und die Summe beider Hebellängen h1+h2 gleich der Distanz S ist. Damit sind die Übersetzung n und die Hebellängen h1, h2 entsprechend den weiter oben angegebenen Beziehungen auf den hier gegebenen Schwenkbereich Φ = 180° abgestimmt. Es ergibt sich daraus, dass in jeder Endlage Ea und Eb des ersten Schwenkhebels 10 beide Schwenkhebel 10 und 12 sich zueinander in Strecklage befinden und der Chipgreifer 20 sich über dem einen Ort A bzw. dem andern Ort B befindet.

Der Hebelmechanismus nach Fig. 1 und 2 hat die Eigenschaften einer Geradführung, d.h. das Ende des zweiten Schwenkhebels 12 (Achse 16) bewegt sich auf einer Geraden G. Dies bedeutet, dass vom Schlitten 18 keinerlei Querkräfte oder Momente auf die Linearführung 19 ausgeübt werden. Diese Führung und die gelenkige Verbindung zwischen Schlitten 18 und Hebel 12 haben im wesentlichen nur die Funktion, die Orientierung des Chipgreifers während seiner Verschiebung aufrechtzuerhalten (bei starrer Verbindung zwischen Hebel 12 und Chipgreifer 20 würde der letztere zusammen mit dem transportierten Chip 30 jeweils um 180° - bezogen auf die Ebenen des Chipträgers 32 und des Substrats 38 - gewendet). Wie anhand der Fig. 1 leicht einzusehen ist, trifft der Chipgreifer mit hoher Genauigkeit jeweils über den Orten A und B ein, dank den Strecklagen der beiden Winkelhebel, in denen ihre Längsachsen bzw. die Achsen 4, 14 und 16 auf der Geraden G liegen. In diesen Strecklagen weist die Anordnung eine hohe Steifigkeit auf. Damit sind wesentliche Voraussetzungen erfüllt für das präzise Abheben der Chips 30 vom Chipträger und deren lagegenaue Montage auf dem Substrat.

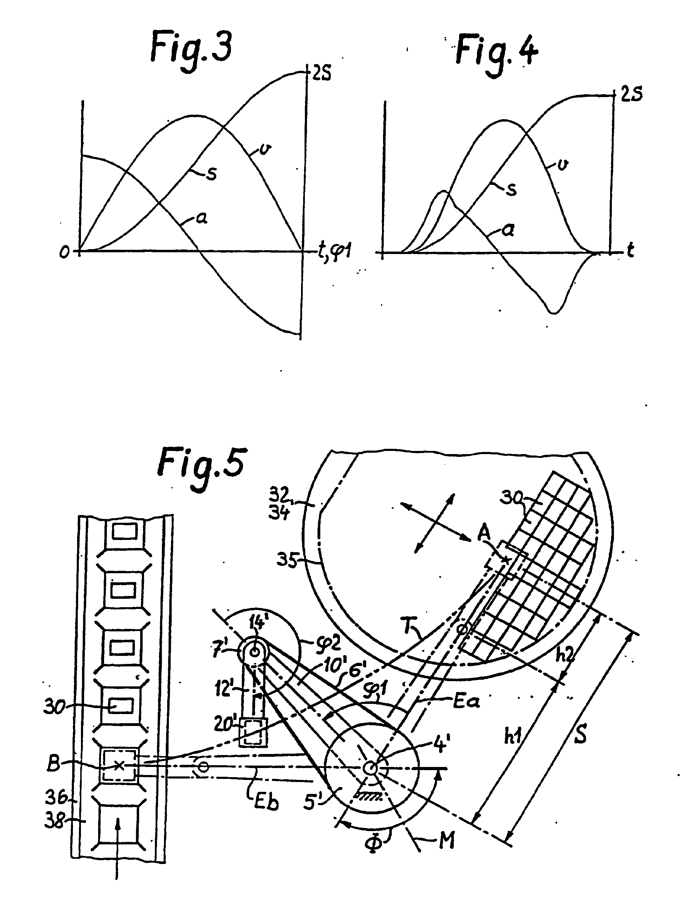

Die Fig. 3 zeigt den zeitlichen Verlauf des Weges s, der Geschwindigkeit v und der Beschleunigung a am Ende des zweiten Schwenkhebels (Achse 16) während eines Bewegungsspiels von A nach B oder umgekehrt, unter der idealisierten Annahme, dass der Schwenkwinkel ϕ1 linear mit der Zeit t verläuft. Wie ersichtlich, verlaufen beim Hebelmechanismus nach Fig. 1 und 2 alle drei Grössen s, v und a nach harmonischen Funktionen. Bei der alternierenden Bewegung ist allerdings ein sprunghaftes Starten und Stoppen des Antriebs, wie bei Fig. 3 angenommen, nicht realistisch. Das Diagramm nach Fig. 4 zeigt einen entsprechenden Verlauf von s, v und a unter praktischen Bedingungen mit "sanftem" Anlauf und Bremsen des Antriebs im Bereich der Endlagen.

Beim Ausführungsbeispiel nach Fig. 1 und 2 erfolgen die Schwenkbewegungen der Hebel 10 und 12 in vertikalen Ebenen, also senkrecht zum Chipträger 32 und zum Substrat 38. Indessen sind auch Ausführungen denkbar, bei denen die Schwenkachsen der Hebel senkrecht stehen und die Hebel sich dementsprechend horizontal in Ebenen bewegen, die zu den Ebenen des Chipträgers und des Substrats parallel liegen. Der Chipgreifer kann dann mit dem Ende des zweiten Schwenkhebels starr verbunden sein, und eine Längsführung (entsprechend der Linearführung 19 in Fig. 1 und 2) ist dann grundsätzlich nicht notwendig. Bei der Orientierung des Chipträgers auf dem Wafertisch ist jedoch zu beachten, dass die Chips auf dem Weg von A nach B in ihrer Ebene um 180° gedreht werden. Auch können bei einer solchen Ausführungsvariante Endanschläge für die vertikale und seitliche Position des Chipgreifers (bzw. des zweiten Schwenkhebels) zweckmässig sein.

In Fig. 5 ist ein weiteres Beispiel einer erfindungsgemässen Halbleiter-Montageeinrichtung im Grundriss dargestellt, mit horizontal schwenkbar angeordneten Schwenkhebeln 10', 12' und gegenüber dem Beispiel nach Fig. 1 und 2 geänderten Parametern. Bei dieser Ausführung beträgt der Schwenkbereich Φ' = 120°, dementsprechend die Übersetzung n = 3 und das Verhältnis der Hebellängen h1/h2 = 2; die Summe h1+h2 der verschieden langen Schwenkhebel ist wiederum gleich der Distanz S zwischen der Achse 4' des ersten Schwenkhebels 10' und dem Ort A bzw. dem Ort B.

Die Achse 4' des ersten Schwenkhebels 10' ist auf der Mittelsenkrechten M zwischen A und B so gelagert, dass in den Endlagen Ea und Eb der Hebel 10' und der zu ihm in der Strecklage befindliche zweite Schwenkhebel 12' auf den Ort A bzw. B weisen. Der hier mit dem Ende des zweiten Hebels 12' starr verbundene Chipgreifer 20' steht dann über dem Ort A bzw. B. Der alternierende (nicht dargestellte) Schwenkantrieb des Hebels 10' kann analog demjenigen nach Fig. 2 ausgeführt sein, wobei jedoch der Schwenkbereich, wie erwähnt, nur 120° beträgt. Die Endlagen Ea und Eb sind wiederum durch entsprechende Steuerung des Antriebsmotors bestimmt. Für den gekoppelten, gegensinnigen Antrieb des zweiten Schwenkhebels 12' dient wieder ein Zahnriemen 6', welcher das feststehende Zahnrad 5' und das Zahnrad 7' umschlingt. Das letztere ist über die Welle 14' mit dem Hebel 12' verbunden, und seine Zähnezahl beträgt 1/3 derjenigen des Rades 5'. Daher beträgt der Schwenkwinkel ϕ2 des Hebels 12' relativ zum Hebel 10' immer das Dreifache des Schwenkwinkels ϕ1 des Hebels 10'.

Jeder Chip 30 erfährt auf dem Weg von A nach B eine Drehung von 120°. Der Wafer 35 muss deshalb entsprechend mit den Chipkanten parallel und senkrecht zu Ea orientiert sein, und auch die Verschiebungen des Wafertisches 34 müssen natürlich so gerichtet sein, wie mit Pfeilen in Fig. 5 angegeben.

Mit den oben genannten Parametern sind also auch bei dieser Variante die Strecklage-Bedingungen für die beiden Schwenkhebel in den Endlagen Ea und Eb erfüllt. Der Chipgreifer 20' bewegt sich hier aber nicht geradlinig zwischen A und B, sondern auf einer gekrümmten Bahn T. Zu dieser Bahn T liegen die Endlagen Ea und Eb in A und B tangential, was bedeutet, dass auch in diesem Fall beim Einlauf des Chipgreifers in A und B die Bewegungskomponenten quer zu Ea und Eb verschwinden. Die vorliegende Anordnung hat somit ähnlich vorteilhafte Eigenschaften wie das vorangehend beschriebene Beispiel.

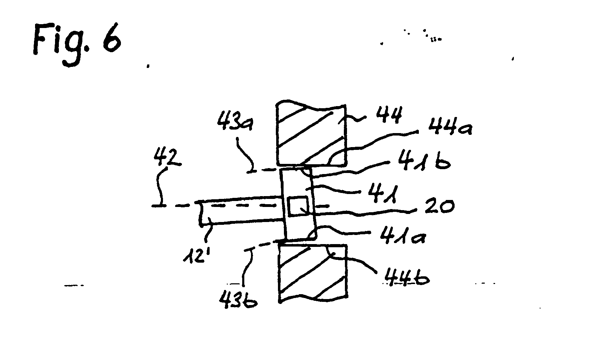

Die Ausbildung der Pick and Place Einrichtung mit den zwei Schwenkhebeln 10' und 12' ermöglicht zudem die Verwendung von Anschlags- oder Begrenzungsmitteln, die die Bewegung des Chipgreifers 20 in den Endlagen Ea und Eb führen und somit ein Schwingen der Schwenkhebel 10' und 12' und damit auch des Chipgreifers 20 beim rasanten Stopp wirksam verhindern. Die Fig. 6 zeigt den Schwenkhebel 12' kurz bevor dieser die Endlage Eb erreicht. Der Schwenkhebel 12' weist ein T-förmiges Ende 41 mit zwei Endflächen 41a und 41b auf. Das Zentrum des Chipgreifers 20 bewegt sich entlang der gestrichelten Linie 42. Die Enden 41a und 41b bewegen sich entlang der Kurven 43a bzw. 43b. Die Pick and Place Einrichtung weist quer zur Bewegungsrichtung des Chipgreifers (20) angeordnete Anschlagsmittel 44 auf, deren Anschlagsflächen 44a und 44b den Kurven 43a bzw. 43b angepasst sind, so dass die Endflächen 41a und 41b des Schwenkhebels 12' auf den Anschlagsflächen 44a bzw. 44b möglichst spielfrei gleiten.

Bei dem Ausführungsbeispiel gemäss den Fig. 1 und 2 könnten Anschlagsmittel anstelle der Linearführung 19 eingesetzt werden.

Die Vorteile einer Pick and Place Einrichtung mit zwei Schwenkhebeln gegenüber einer Pick and Place Einrichtung mit einem einzigen Schwenkhebel liegen insbesondere darin, dass das Stoppen des Chipgreifers 20 in den Endlagen Ea und Eb durch Anschlagsmittel verbessert werden kann, und dass während der Schwenkbewegung infolge kürzerer Hebelarme kleinere Zentrifugalkräfte auftreten und somit der Antrieb weniger Energie benötigt.

## Patentansprüche

1. Halbleiter-Montageeinrichtung mit einem Chipgreifer (20), welcher zwischen einem ersten Ort (A) und einem zweiten Ort (B) mittels eines Hebelmechanismus hin und her bewegbar ist, um jeweils am ersten Ort einen Chip (30) von einem Chipträger (32) abzuheben und am zweiten Ort den Chip auf ein Substrat (38) abzulegen, wobei ein erster Schwenkhebel (10) auf einer im gleichen Abstand (S) vom ersten (A) und vom zweiten Ort (B) gelagerten Antriebswelle (4) sitzt und mit wechselnder Schwenkrichtung zwischen zwei Endlagen (Ea, Eb) angetrieben ist, in denen der Schwenkhebel (10) je zur Seite des einen (A) oder des anderen Ortes (B) hin weist, **gekennzeichnet durch** einen zweiten Schwenkhebel (12), der am Ende des ersten Schwenkhebels (10) gelagert und in Bezug auf dessen Schwenkrichtung gegensinnig und mit bestimmter Übersetzung (n) zu dessen Schwenkbewegung angetrieben ist und der an seinem Ende mit dem Chipgreifer (20) verbunden ist; wobei die genannte Übersetzung (n) und die Längen (h1, h2) beider Schwenkhebel (10, 12) so aufeinander abgestimmt sind, dass in beiden Endlagen (Ea, Eb) des ersten Schwenkhebels (10) beide Schwenkhebel (10, 12) sich zueinander in Strecklage befinden und der Chipgreifer (20) über dem einen (A) bzw. dem andern Ort (B) angelangt ist.

2. Halbleiter-Montageeinrichtung nach Anspruch 1, **dadurch gekennzeichnet, dass** der Schwenkbereich (Φ) zwischen den Endlagen (Ea, Eb) des ersten Schwenkhebels (10) gleich 180°, die Übersetzung (n) zwischen beiden Schwenkhebeln (10, 12) gleich 2 und das Längenverhältnis (h1/h2) beider Schwenkhebel (10, 12) gleich 1 ist.

3. Halbleiter-Montageeinrichtung nach Anspruch 1 oder 2, **dadurch gekennzeichnet, dass** am Ende des zweiten Schwenkhebels (12) ein Schlitten (18) angelenkt ist, der entlang eines Führungsorgans (19) verschiebbar ist und den Chipgreifer (20) trägt.

4. Halbleiter-Montageeinrichtung nach einem der Ansprüche 1 bis 3, **dadurch gekennzeichnet, dass** die beiden Schwenkhebel (10, 12) in Ebenen schwenken, die senkrecht zum Substrat (38) stehen.

5. Halbleiter-Montageeinrichtung nach Anspruch 1, **dadurch gekennzeichnet, dass** die beiden Schwenkhebel (10', 12') in Ebenen schwenken, die parallel zum Substrat (38) liegen.

6. Halbleiter-Montageeinrichtung nach Anspruch 5, **dadurch gekennzeichnet, dass** der Schwenkbereich (Φ) zwischen den Endlagen (Ea, Eb) des ersten Schwenkhebels (10') gleich 120°, die Übersetzung (n) zwischen beiden Schwenkhebeln (10, 12) gleich 3 und das Längenverhältnis (h1/h2) beider Schwenkhebel (10', 12') gleich 2 ist.

7. Halbleiter-Montageeinrichtung nach Anspruch 5 oder 6, **dadurch gekennzeichnet, dass** der Chipgreifer (20') mit dem Ende des zweiten Schwenkhebels (12') starr verbunden ist.

8. Halbleiter-Montageeinrichtung nach einem der Ansprüche 1 bis 7, **dadurch gekennzeichnet, dass** der zweite Schwenkhebel (12) auf einer Welle (14) gelagert ist, auf der ein Zahnrad (7) sitzt, welches von einem zur Antriebswelle (4) koaxialen, feststehenden Zahnrad (5) über einen Zahnriemen (6) oder ein am ersten Schwenkhebel (10) gelagertes Zwischenrad angetrieben ist.

9. Halbleiter-Montageeinrichtung nach einem der Ansprüche 1 bis 8, **dadurch gekennzeichnet, dass** in den Endlagen (Ea, Eb) quer zur Bewegungsrichtung des Chipgreifers (20) angeordnete Anschlagsmittel (44) für den zweiten Schwenkhebel (12; 12') vorhanden sind.

## Claims

1. Semi-conductor mounting apparatus with a chip gripper (20) which is moveable back and forth between a first location (A) and a second location (B) by means of a lever mechanism, in order to pick a chip (30) from a chip carrier (32) at the first location and to place the chip on a substrate (38) at the second location, wherein a first pivoted lever (10) is seated on a shaft (4) mounted equidistantly between the first location (A) and the second location (B) and is driven in alternating pivoting directions between two end positions (Ea, Eb), in which the pivoted lever (10) is directed towards one (A) or the other location (B), **characterised by** a second pivoted lever (12) seated on the end of the first pivoted lever (10) and driven the opposite way around with respect to the direction of pivoting thereof and with a predetermined gear ratio (n) with respect to the pivoting movement thereof, and which at its end is connected to the chip gripper (20); wherein said gear ratio (n) and the lengths (h1, h2) of the two pivoted levers (10, 12) are matched to each other such that in the two end positions (Ea, Eb) of the first pivoted lever (10), the two pivoted levers (10, 12) are in an extended position with respect to one another and the chip gripper (20) has arrived over one (A) or the other location (B).

2. Semi-conductor mounting means according to claim 1, **characterised in that** the range of pivoting (Φ) between the end positions (Ea, Eb) of the first pivoted lever (10) equals 180°, the gear ratio (n) between the two pivoted levers (10, 12) equals 2, and the ratio of lengths (h1, h2) of the two pivoted levers (10, 12) equals 1.

3. Semi-conductor mounting apparatus according to claim 1 or 2, **characterised in that** on the end of the second pivoted lever (12) there is coupled a slide (18) which can be displaced along a guide member (19) and carries the chip gripper (20).

4. Semi-conductor mounting means according to any of claims 1 to 3, **characterised in that** the two pivoted levers (10, 12) pivot in planes which are perpendicular to the substrate (38).

5. Semi-conductor mounting means according to claim 1, **characterised in that** the two pivoted levers (10', 12') pivot in planes which lie parallel to the substrate (38).

6. Semi-conductor mounting means according to claim 5, **characterised in that** the pivoting range (Φ) between the end positions (Ea, Eb) of the first pivoted lever (10') equals 120°, the gear ratio (n) between the two pivoted levers (10', 12') equals 3, and the ratio of lengths (h1, h2) of the two pivoted levers (10', 12') equals 2.

7. Semi-conductor mounting means according to claim 5 or 6, **characterised in that** the chip gripper (20') is rigidly connected to the end of the second pivoted lever (12').

8. Semi-conductor mounting means according to any of claims 1 to 7, **characterised in that** the second pivoted lever (12) is seated on a shaft (14) upon which a toothed wheel (7) is seated, which is driven by a toothed wheel (5) fixed on and coaxial to the drive shaft (4) via a toothed belt (6) or an intermediate wheel mounted on the first pivoted lever (10).

9. Semi-conductor mounting means according to any of claims 1 to 7, **characterised in that** at the end positions (Ea, Eb) delimiter means 44 for the second pivot lever (12') are arranged laterally to the direction of movement of the chip gripper 20.

## Revendications

1. Dispositif de montage de semi-conducteurs, comprenant un préhenseur de puces (20) qui peut être déplacé en va-et-vient entre un premier emplacement (A) et un second emplacement (B) au moyen d'un mécanisme à levier, respectivement pour soulever une puce (30) depuis un porte-puces (32) sur le premier emplacement et pour déposer la puce sur un substrat (38) sur le second emplacement, dispositif dans lequel un premier levier de pivotement (10) qui est placé sur un arbre d'entraînement (4) monté à équidistance du premier emplacement (A) et du second emplacement (B) et qui est entraîné avec une direction de pivotement alternante entre deux positions de fin de course (Ea, Eb) dans lesquelles le levier de pivotement (10) montre respectivement vers le côté dudit un emplacement (A) ou de l'autre emplacement (B), **caractérisé par** un second levier de pivotement (12) qui est monté sur l'extrémité du premier levier de pivotement (10) et qui est entraîné en sens contraire en référence à la direction de pivotement de ce dernier et avec une certaine multiplication (n) par rapport au mouvement de pivotement de ce dernier et qui est relié sur son extrémité avec le préhenseur de puces (20) ; sachant que la multiplication mentionnée (n) et les longueurs (h1, h2) des deux leviers de pivotement (10, 12) sont accordées les unes aux autres de telle sorte que, dans les deux positions de fin de course (Ea, Eb) du premier levier de pivotement (10), les deux leviers de pivotement (10, 12) se trouvent en position d'extension l'un par rapport à l'autre et que le préhenseur de puces (20) est arrivé au-dessus dudit un emplacement (A) ou de l'autre emplacement (B).

2. Dispositif de montage de semi-conducteurs selon la revendication 1, **caractérisé en ce que** la plage de pivotement (Φ) entre les positions de fin de course (Ea, Eb) du premier levier de pivotement (10) est égale à 180°, **en ce que** la multiplication (n) entre les deux leviers de pivotement (10, 12) est égale à 2 et **en ce que** le rapport des longueurs (h1/h2) des deux leviers de pivotement (10, 12) est égal à 1.

3. Dispositif de montage de semi-conducteurs selon l'une ou l'autre des revendications 1 et 2, **caractérisé en ce qu'**un chariot (18) qui peut être déplacé en translation le long d'un organe de guidage (19) et qui porte le préhenseur de puces (20), est monté en articulation sur l'extrémité du second levier de pivotement (12).

4. Dispositif de montage de semi-conducteurs selon l'une des revendications 1 à 3, **caractérisé en ce que** les deux leviers de pivotement (10, 12) pivotent dans des plans qui sont perpendiculaires au substrat (38).

5. Dispositif de montage de semi-conducteurs selon la revendication 1, **caractérisé en ce que** les deux leviers de pivotement (10', 12') pivotent dans des plans qui sont parallèles au substrat (38).

6. Dispositif de montage de semi-conducteurs selon la revendication 1, **caractérisé en ce que** la plage de pivotement (Φ) entre les positions de fin de course (Ea, Eb) du premier levier de pivotement (10') est égale à 120°, **en ce que** la multiplication (n) entre les deux leviers de pivotement (10, 12) est égale à 3 et **en ce que** le rapport des longueurs (h1/h2) des deux leviers de pivotement (10', 12') est égal à 2.

7. Dispositif de montage de semi-conducteurs selon l'une ou l'autre des revendications 5 et 6, **caractérisé en ce que** le préhenseur de puces (20') est en liaison rigide avec l'extrémité du second levier de pivotement (12').

8. Dispositif de montage de semi-conducteurs selon l'une des revendications 1 à 7, **caractérisé en ce que** le second levier de pivotement (12) est monté sur un arbre (14) qui est placé sur une roue dentée (7), laquelle est entraînée par une roue dentée (5) stationnaire et coaxiale à l'arbre d'entraînement (4) par l'intermédiaire d'une courroie dentée (6) ou d'une roue intermédiaire montée sur le premier levier de pivotement (10).

9. Dispositif de montage de semi-conducteurs selon l'une des revendications 1 à 7, **caractérisé en ce que** des moyens de butée (44) agencés perpendiculairement à la direction de mouvement du préhenseur de puces (20) sont présents dans les positions de fin de course (Ea, Eb) pour le second levier de pivotement (12; 12').
